# EUROPEAN PATENT SPECIFICATION

(11) **EP 2 971 945 B1**
(45) Date of publication and mention of the grant of the patent: **02.05.2018**
(21) Application number: 14765038.6
(22) Date of filing: 17.03.2014
(51) Int. Cl.: F21V 5/04, F21V 7/00, F21V 13/04, F21V 5/08, F21Y 115/10

(54) **LED ASSEMBLY HAVING A REFLECTOR OR REFRACTOR THAT PROVIDES IMPROVED LIGHT CONTROL**
LED-ANORDNUNG MIT REFLEKTOR ODER REFRAKTOR FÜR VERBESSERTE LICHTSTEUERUNG
ENSEMBLE DEL COMPRENANT UN RÉFLECTEUR OU UN RÉFRACTEUR PERMETTANT UNE MEILLEURE COMMANDE DE LA LUMIÈRE

(30) Priority: 15.03.2013 US 201313837731; 15.03.2013 US 201313838139
(43) Date of publication of application: 20.01.2016
(73) Proprietor: ABL IP Holding LLC, Atlanta, GA 30309 (US)
(72) Inventor: CHEN, Jie, Snellville, GA 30078 (US); MARQUARDT, Craig, Eugene, Covington, GA 30014 (US); WEISS, Daniel, Aaron, Tucker, GA 30084 (US); SEKOWSKI, Daniel, Vincent, Loganville, GA 30052 (US); ABDELSAMED, Yaser, S., Granville, OH 43023 (US)
(74) Representative: Thompson, Andrew John
(86) International application number: PCT/US2014/030628
(87) International publication number: WO 2014/145802

(56) References cited:
- WO-A1-2010/019810
- WO-A2-2012/118828
- US-A1- 2003 063 476
- US-A1- 2006 072 314
- US-A1- 2007 242 441
- US-A1- 2010 014 290
- US-A1- 2010 302 786
- US-A1- 2011 215 721
- US-A1- 2012 287 649
- US-A1- 2012 307 503

## Description

### BACKGROUND

Light emitting diodes (LEDs) are used in a variety of general lighting applications such as streetlights, parking garage lighting, and parking lots. LEDs have reached efficiency values per watt that outpace almost all traditional light sources. LEDs, however, can be expensive in lumens per dollar compared to light sources. Because of the high cost of using LEDs, optical, electronic and thermal efficiencies can be very important. In direction lighting applications, such as street lighting, it is inefficient to illuminate the house side of the street rather than direct all the light toward the street. Total internal reflection (TIR) lenses have been used to successfully direct house-side light toward the street. But these TIR solutions are still not very efficient.

### BRIEF SUMMARY

This summary is a high-level overview of various aspects of the invention and introduces some of the concepts that are further described in the Detailed Description section below. This summary is not intended to identify key or essential features of the claimed subject matter, nor is it intended to be used in isolation to determine the scope of the claimed subject matter. The subject matter should be understood by reference to the entire specification of this patent, all drawings and each claim.

The first aspect of the invention includes a light assembly for distributing light in a preferred direction, the light assembly comprising: a light emitter having an emitter axis; a lens; positioned over the light emitter, the lens having an outer surface and an inner surface that defines a lens cavity; a separate optical element attached to the lens, comprising at least one optical element surface that extends towards the light emitter, wherein the optical element terminates in a tip and wherein a portion of the optical element extends within the lens cavity toward the light emitter and is shaped to refract light emitted from the light emitter toward a non-preferred direction so that the refracted light exits the lens toward the preferred direction; and a reflector positioned within the lens cavity, wherein the reflector is shaped to reflect light emitted from the light emitter toward the non-preferred direction so that the reflected light exits the lens toward the preferred direction. In the second aspect of the invention there is provided a method for distributing light from a light fixture, the light fixture including a light emitter, a lens, an optical element which is separate from the lens and attached to the lens, and a reflector, the method comprising: producing light with the light emitter such that a first portion of the light is initially directed toward a preferred direction, and a second portion of the light and a third portion of the light are initially directed toward a non-preferred direction; using the optical element, refracting the second portion of the light such that the second portion of the light exits the lens towards the preferred direction; using the reflector, reflecting the third portion of the light such that the third portion of the light travels toward the optical element; and using the optical element, refracting the third portion of the light reflected by the reflector such that the third portion of the light exits the lens toward the preferred direction, wherein the lens has an inner surface which defines a lens cavity comprising a preferred-side void and a non-preferred-side void, and further wherein a portion of the optical element extends within the preferred-side void of the lens cavity toward the light emitter and the reflector is positioned within the non-preferred-side void of the lens cavity.

US patent application no. 12/475,194 discloses a lens for distribution of light predominantly toward a preferential side from a light emitter having an emitter axis and defining an emitter plane. Front and back sectors of the lens differ in their respective configurations for refracting light from the emitter.

US patent application no. 13/441,540 discloses a lighting apparatus having a first lens over the LED emitter and a second lens over the first lens. The apparatus comprises a first-lens outer surface configured to refract light from the emitter, a second-lens inner surface spaced from the first-lens outer surface, and a second-lens outer surface configured to refract light from the second-lens inner surface toward a preferential side.

US patent application no. 13/107,388 discloses a light directing apparatus which includes an optical substrate having a first side and a second side wherein there a various protrusions on the substrate in order to redirect emitted light.

US patent application no. 12/173,149 discloses a light-directing apparatus for off-axial preferential-side distribution of light from a light emitter, including a secondary lensing member positioned over a primary lens of an LED and a shield member embedded within the secondary lensing member.

PCT patent application no. PCT/US2012/026971 discloses an optic to be placed over a light source for refracting light from the light source in a preferred direction.

### BRIEF DESCRIPTION OF THE DRAWINGS

Illustrative embodiments of the present invention are described in detail below with reference to the following drawing figures:
Figure 1 shows a cross-section of one embodiment of an LED assembly.
Figure 2 shows another cross-section of the LED assembly of Figure 1.
Figure 3 shows a cross-section of an alternative embodiment of an LED assembly.
Figure 4 shows a cross-section of yet another alternative embodiment of an LED assembly.
Figure 5 shows a cross-section of still another alternative embodiment of an LED assembly.
Figure 6 shows a cross-section of yet another alternative embodiment of an LED assembly.
Figure 7 shows a bottom perspective view of one embodiment of a lens for use in an embodiment of an LED assembly.
Figures 8-14 show views of various shape geometries that embodiments of optical elements can assume.
Figure 15 is a bottom perspective view of an embodiment of an optical element in isolation.
Figure 16 is a cross-sectional view of the lens of Figure 7 positioned over a light emitter.
Figure 17 is a cross-sectional view of an alternative embodiment of an LED assembly that includes the lens of Figure 7 and a reflector.
Figure 18 is a bottom perspective view of the lens and reflector shown in Figure 17.

### DETAILED DESCRIPTION

The subject matter of embodiments of the present invention is described here with specificity to meet statutory requirements, but this description is not necessarily intended to limit the scope of the claims. The claimed subject matter may be embodied in other ways, may include different elements or steps, and may be used in conjunction with other existing or future technologies. This description should not be interpreted as implying any particular order or arrangement among or between various steps or elements except when the order of individual steps or arrangement of elements is explicitly described.

Embodiments of the invention include an LED assembly that includes optics and optical arrangements for light emitting diodes (LEDs). In some embodiments, a reflector is provided within a void between the lens and the LED. This reflector can reflect light emitted by the LED in a non-preferred direction back toward the preferred direction. In other embodiments, an optical element is formed or otherwise provided in the lens cavity and shaped so that, when the lens is positioned above the LED, the refractor bends the emitted light in a preferred direction. In some embodiments, both a reflector and optical element are provided in the LED assembly to control the directionality of the emitted light. Such embodiments of the invention can be used to increase the efficiency of an LED by ensuring that generated light is being directed to the target area of choice.

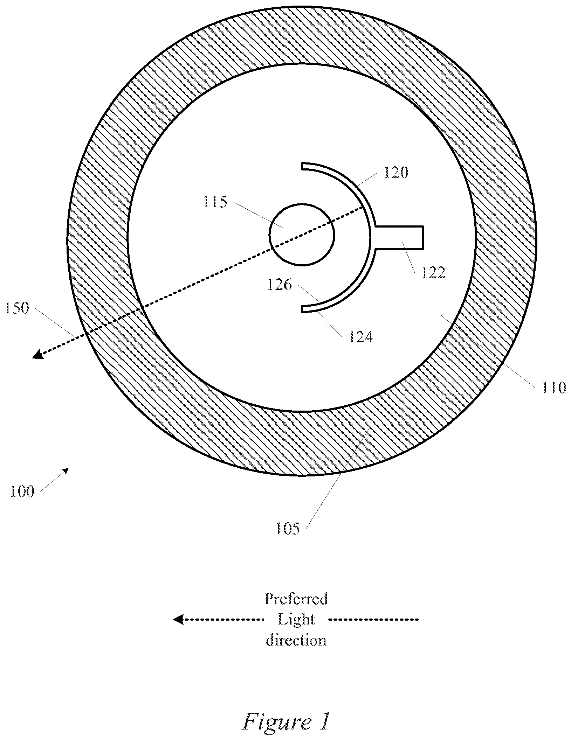

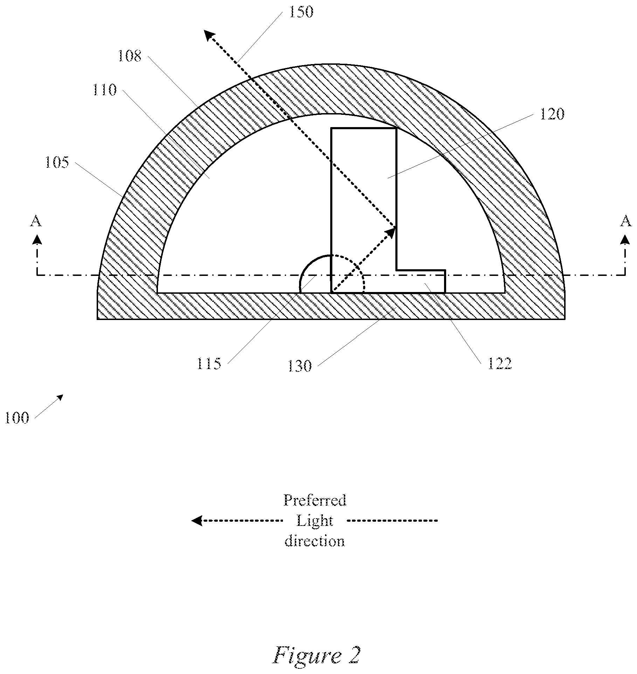

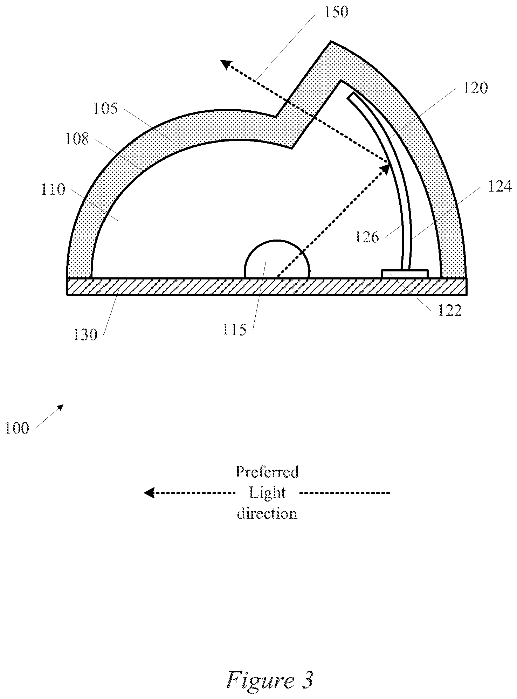

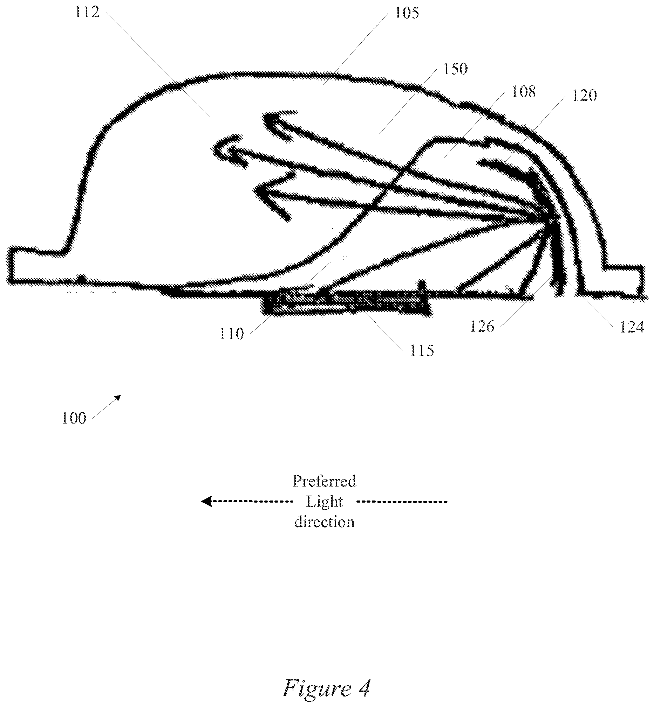

Figure 1 shows a top view of an LED assembly 100 cut along line A-A of the cross-sectional view of LED assembly 100 shown in Figure 2. Referring to both these figures, LED assembly 100 can include light emitter 115 disposed within lens 105 such that a void 110 exists between the lens 105 and light emitter 115 and surrounds light emitter 115. In some embodiments, void 110 can be semi-hemispherical, but void 110 is certainly not intended to be limited to this geometry. Rather, the inner surface 108 of the lens 105, and thus the shape of void 110 dictated by such inner surface 108, can be of any desired shape. For example, Figure 3 illustrates another embodiment of the LED assembly 100 where the inner surface 108 of the lens 105 is not semi-hemispherical. Figure 4 illustrates a cross-section of another embodiment of LED assembly 100 where the inner surface 108 of lens 105 is shaped so as to create a thick lens portion 1120.

Light emitter 115 can be any type of light emitter known in the art. For example, light emitter 115 can include a light emitter made from Aluminum gallium arsenide (AlGaAs), Gallium arsenide phosphide (GaAsP), Aluminum gallium indium phosphide (AlGaInP), Gallium(III) phosphide (GaP), Aluminum gallium phosphide (AlGaP), Zinc selenide (ZnSe), Indium gallium nitride (InGaN), Silicon carbide (SiC) Silicon (Si), or Indium gallium nitride (InGaN).

In some embodiments, lens 105 can include plastic, glass, silicon, epoxy, or acrylic material. These materials may or may not be optical grade.

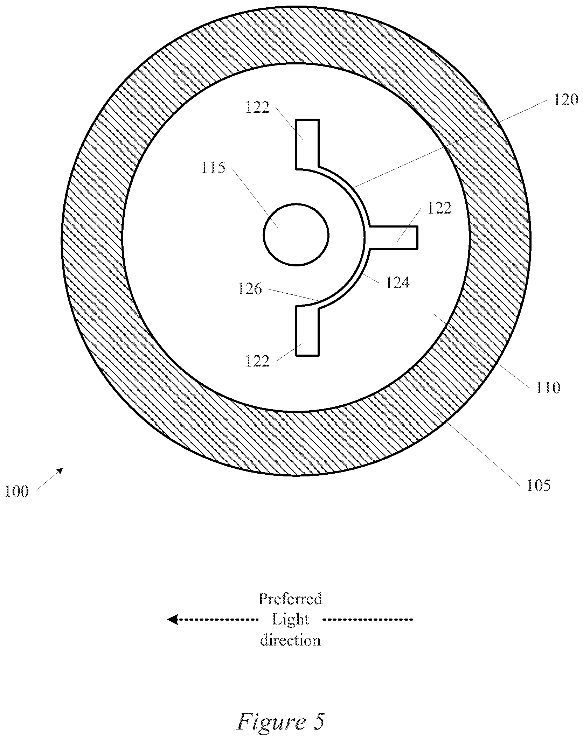

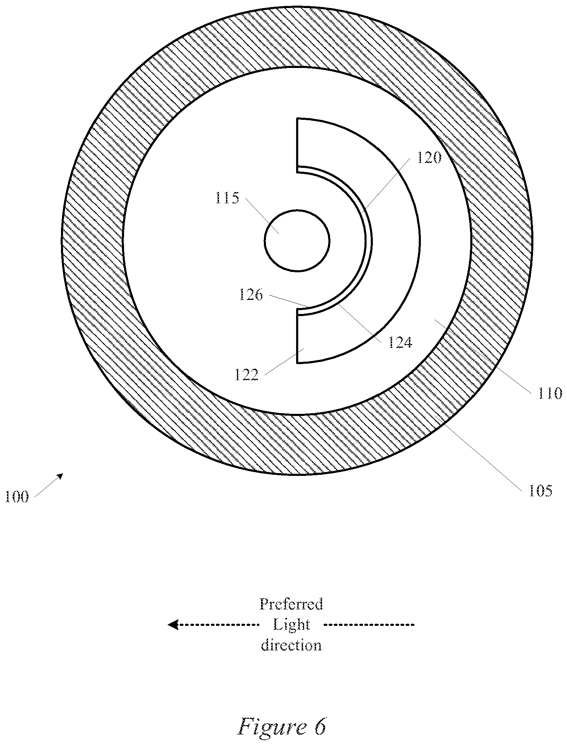

Embodiments of LED assembly 100 includes reflector 120 that is positioned within the void 110 so as to extend at least partially around the light emitter 115. Retention structure, such as tab 122, can be provided on reflector 120 and used to secure reflector 120 to circuit board 130 within LED assembly 100. The reflector 120 may include more than one tab 122 (see Figure 5) or the tab may be a continuous tab that extends all the way or partially around the base of reflector 120, as shown in Figure 6. The tab 122 can have any geometry that permits it to attach the reflector 120 to the circuit board 130. Moreover, any retention structure that permits the reflector 120 to be attached to the circuit board 130 may be used and certainly is not limited to the tab geometry disclosed herein.

Tab 122 can be secured to circuit board 130 using any attachment scheme, for example, using solder, a screw, staple, glue, adhesive, heat bonding, rivets, push tab connectors, slot tab connectors, etc. In some embodiments, reflector 120 can be coupled directly with the top surface of circuit board 130. Using these tabs 122, the reflector 120 is secured directly to circuit board 130 and not to lens 105. In some embodiments, for example, reflector 120 may not be in contact with lens 105.

In some embodiments reflector 120 can be secured to the circuit board using a light emitter holder (e.g., an LED COB array holder). A light emitter holder can be used to secure an LED to a circuit board or a substrate. Some LEDs are powered with contacts that are not soldered to a circuit board. Instead, a light emitter holder can be screwed to the circuit board in such a way to hold and secure the light emitter in place on the circuit board and to keep the necessary electrical contacts in place. Such a light emitter holder can be used to secure the reflector to the circuit board. For instance, the reflector can include tab 122 with a hole that is sized to correspond with the screw (or bolt) that secures light emitter holder into place. Tab 122 can be secured to the circuit board using the same screw that secures the light emitter holder. This screw can pass through the hole in tab 122. Reflector 120 can be placed above or beneath light emitter holder. In some embodiments, reflector 120 can pressed to the circuit board with the light emitter holder with or without the screw passing through tab 122.

Reflector 120 can have shape and/or dimension (e.g., height) that permits the reflector 120 to fit within void 110. In the illustrated embodiment of Figure 1, the reflector 120 has a semi-circular shape so as to curve around light emitter 115 and azimuthally surround light emitter 115 around 180°. In other examples, reflector 120 can azimuthally surround light emitter 115 around 270°, 225°, 135°, 90°, etc. However, the reflector 120 is not limited to the illustrated semi-circular shape but rather can have any desired shape, including semi-oval or elliptical cross sectional shapes. In some embodiments, reflector 120 may include a continuous curve that wraps around light emitter 115.

While Figure 1 illustrates the reflector 120 as having a consistent cross-sectional shape (i.e., an inner surface 126 and an outer surface 124 of the same shape), it need not. Rather, the inner surface 126 and outer surface 124 can be of different shapes. The inner surface 126 of the reflector 120 can be of any shape that effectuates the desired reflection of light in a preferred light direction, as discussed below. This includes, but is not limited to, an inner surface 126 having an elliptical, parabolic shape or irregular geometry. In some embodiments, reflector 120 can comprise a plurality of reflectors.

In some embodiments, reflector 120 does not only extend around the light emitter 115 but rather can also extend partially over the light emitter 115 so as to reflect nearly vertical light emitted by the light emitter 115.

The reflector 120 may be formed of any suitable material, including polymeric materials (e.g., optical grade polyesters, polycarbonates, acrylics, etc.) or metallic materials (e.g., prefinished anodized aluminum (e.g. Alanod Miro), prefinished anodized silver (e.g. Alanod Miro Silver), painted steel or aluminum, etc.). Regardless of the material from which the reflector 120 is formed, the inner surface 126 of the reflector should have a high surface reflectivity, preferably, but not necessarily, between 96%-100%, inclusive, and more preferably 98.5-100%, inclusive.

Reflector 120 is shaped and positioned relative to light emitter 115 to direct light from the light emitter 115 in a desired or preferred direction. In use, light emitted from light emitter 115 in a non-preferred direction impinges upon the inner surface 126 of reflector 120, which in turn reflects the light in the preferred direction. For example, light ray(s) 150 exits light emitter 115, hits the inner surface 126 of reflector 120, and is reflected back in the preferred light direction (as viewed from above). Again, the positioning of the reflector 120 within void 110 and the shape of the inner surface 126 of the reflector 120 can be controlled to achieve the desired directionality of the reflected light. In Figure 4, light rays the light rays 150 are reflected back through thick lens portion 112 toward the preferred light direction. The thickness and/or shape of thick lens portion 112 may be dictated, for example, by the desired outward surface shape and/or any refracting requirements.

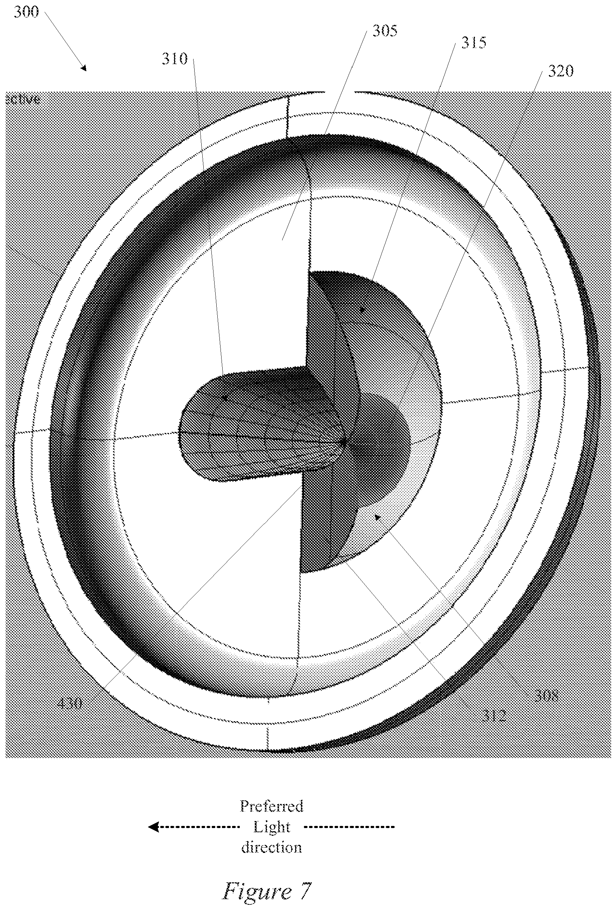

Figure 7 shows the underside of lens 300 according to the invention. Lens 300 includes an outer surface and inner surface 305 that defines a lens cavity 308. The lens cavity 308 can be formed so as to control the directionality of the light emitted from the lens 300.

The lens cavity 308 includes a preferred-side void 310 and non-preferred-side void 315. Each void 310, 315 can be of any shape and is certainly not limited to the geometries shown in the Figures. Non-preferred-side void 315 can have a semi-hemispherical cross-sectional shape or a semi-ovoid cross-sectional shape. Preferred-side void 310 can also have a semi-hemispherical cross-sectional shape or a semi-ovoid cross-sectional shape. Preferred-side void 310 can also have some linear portions or parabolic portions. The two voids 310 and 315 can be cut, etched, or molded into lens 300.

Lens 300 can be positioned over a light emitter or other light source. In some embodiments, the light emitter can be centrally disposed between the two voids 310 and 315. In other embodiments, the light emitter can be positioned in one or the other void 310 or 315.

An optical element 320 may also be provided in the lens cavity 308. The optical element 320 is a separate component that is attached to the lens 300 within the lens cavity 308. The optical element 320 may have any desired shape not inconsistent with the objectives of the present invention to capture and direct light in a preferred light direction.

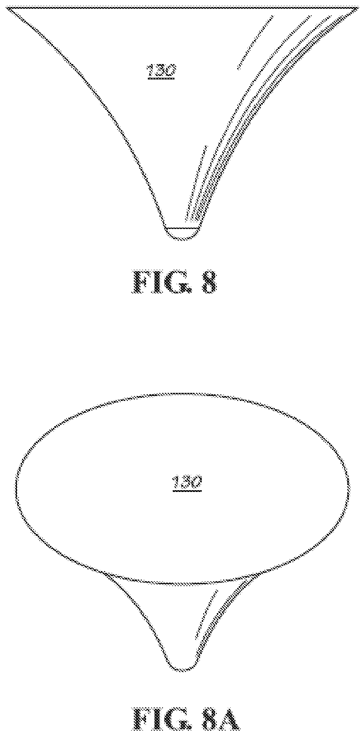

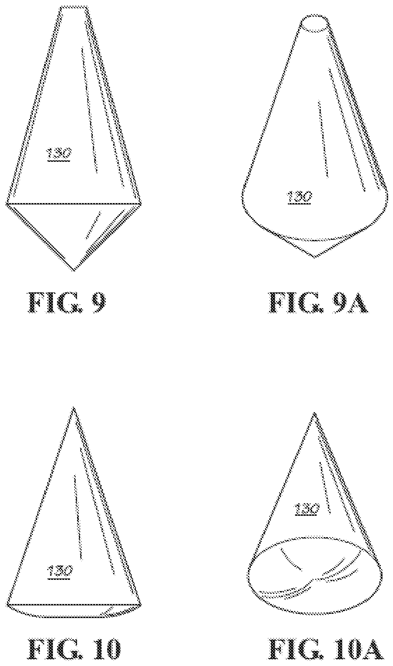

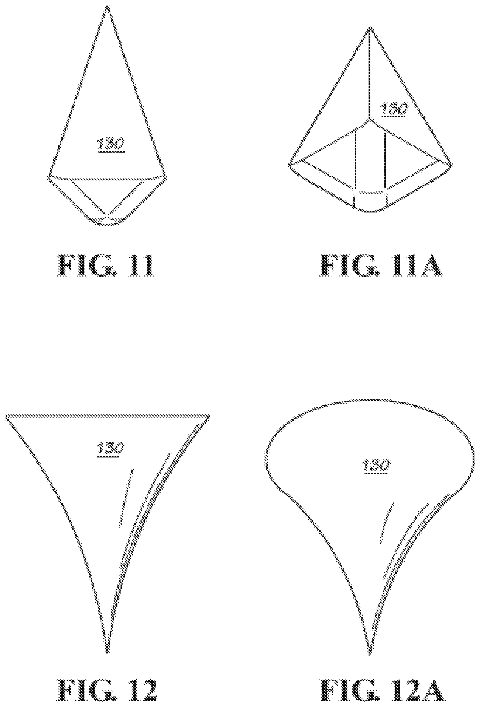

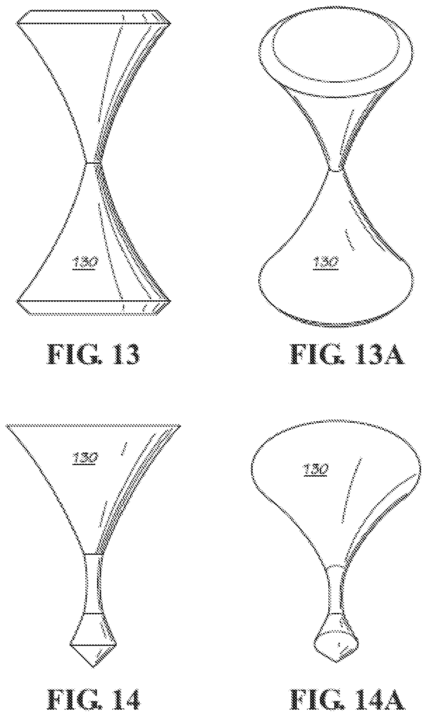

Figures 8-14 illustrate in isolation various non-limiting shape geometries that optical element 320 may assume according to some embodiments. In particular, the optical element 320 may include a conical shape with a tapered side and smooth distal tip (Figs. 8 and 8A), a dual-conical shape (Figs. 9 and 9A), a conical shape with a rounded base (Figs. 10 and lOA), a dual-pyramidal shape (Figs. 11 and 11A), a conical shape with a tapered side and pointed distal tip (Figs. 12 and 12A), an hourglass shape (Figs. 13 and 13A) or a modified hourglass shape (Figs. 14 and 14A).

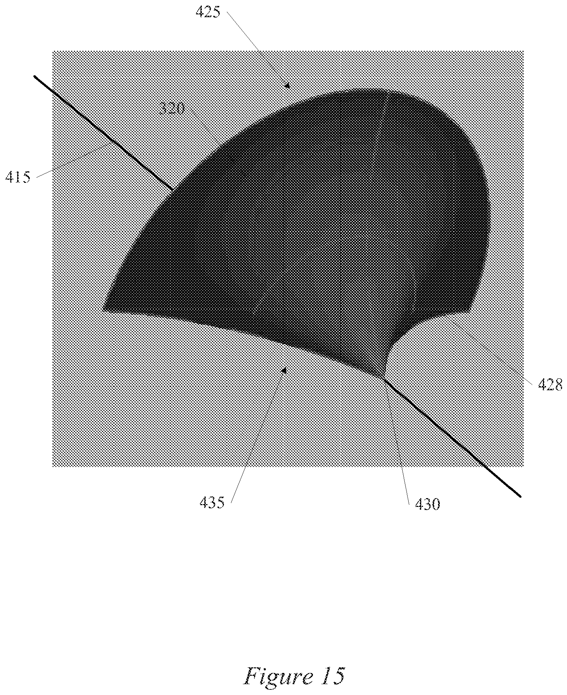

Note, however, that the optical element 320 need not, and often will not, include the entirety of a shape geometry, such as those shown in Figures 8-14. For example, only a portion of such shapes may form the optical element 320 that is formed or otherwise provided in the lens cavity 308. Figure 7 shows an embodiment of a lens 300 having an optical element 320 provided in the lens cavity 308, and Figure 15 shows the optical element 320 of Figure 7 in isolation. The optical element 320 of Figure 15 has a substantially conical shape with an upper plane 425, a flat side wall 435, and a curved side wall428 that tapers downwardly from the upper plane 425 into a distal tip 430. Axis 415 extends through tip 430. Optical element 320 of Figure 15 is similar to the shape of Figure 7 if such shape was sliced longitudinally down the middle (thereby creating flat side wall 435). Again, however, the optical element 320 may be of any shape and/or dimension. For example, upper plane 425 can azimuthally circumscribe a semi-circle or circle around axis 415. Upper plane 425 may also include an ellipse or semi-ellipse with axis 415 extending through one foci of the ellipse or through the center of the ellipse.

In some embodiments, at least one surface of the optical element 320 may be reflective. In some embodiments, such surface may have a surface reflectivity between 90%-99.5%, inclusive; possibly 93%-96%, inclusive; and more preferably 98.5%-99%, inclusive. Such reflectivity may be achieved by forming the optical element 320 from a highly reflective material or alternatively treating the surface of the optical element 320 so as to achieve such reflectivity.

As seen in Figure 7, optical element 320 extends downwardly into the lens cavity 308. In some embodiments, axis 415 can be parallel with the axis of the light emitter and/or lens 305. In other embodiments, axis 415 and the light emitter axis can be the same axis and/or lens 305.

While certainly not required, at least a portion of optical element 320 may reside in the non-preferred-side void 315 (as shown in Figure 7) so as to be available to redirect light emitted into the non-preferred-side void 315, as discussed below. In this embodiment, the flat side wall 435 of optical element 320 abuts the plane 312 that separates non-preferred-side void 315 and preferred-side void 310.

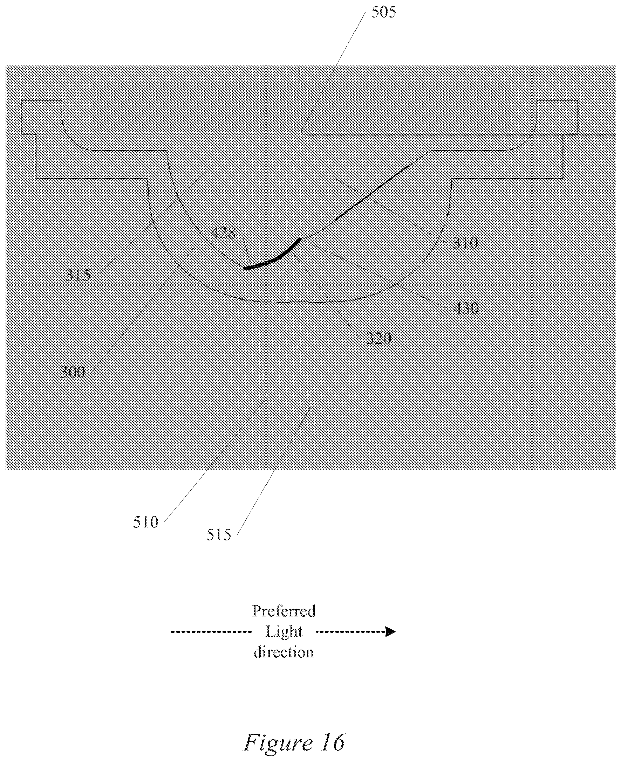

As shown in Figure 16, optical element 320 can direct light from a light source (e.g., LED) that is emitted into the non-preferred direction (i.e., in the non-preferred-side void 315) back toward the preferred light direction. Light emitter 505 can produce light following light rays 510 and 515. These light rays can pass through lens 300. In particular, these light rays pass through optical element 320. Light rays 510 and 515 are originally directed into non-preferred-side void 315 but impinge optical element 320 that, in turn, refracts light rays 510 and 515 so that they exit lens 300 in the preferred direction.

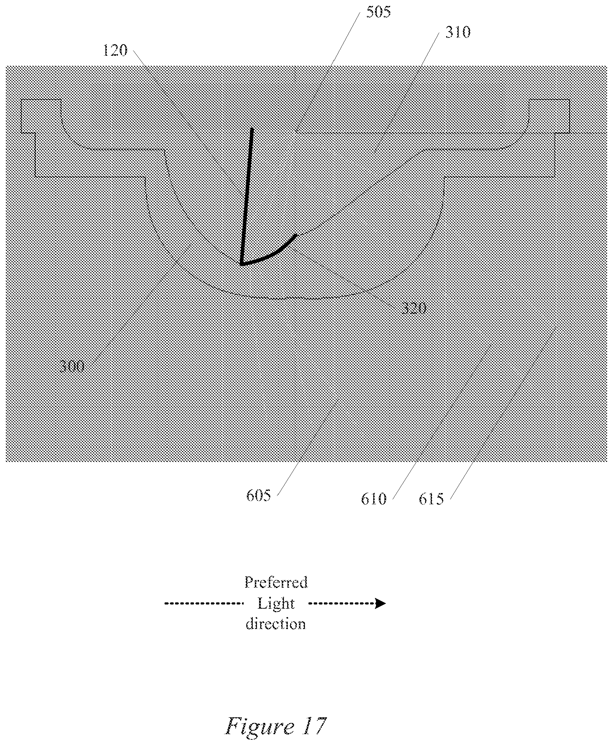

Figure 17 shows ray traces from a light emitter 505 emitted through lens 300 having both optical element 320 and reflector 120, according to the invention. In particular, light ray 605 is reflected off reflector 120 and is refracted via optical element 320. The combined reflection and refraction directs the light in the preferred light direction. As discussed above, in some embodiments reflector 120 is attached directly to a circuit board and is not supported by the lens.

Light rays 610 and 615 are refracted through lens 300 in the preferred light direction. Light ray 615 enters preferred-side void 310 prior to being refracted through lens 300. Light ray 610 is reflected off of reflector 120, enters preferred-side void 310, and exits after being refracted through lens 300.

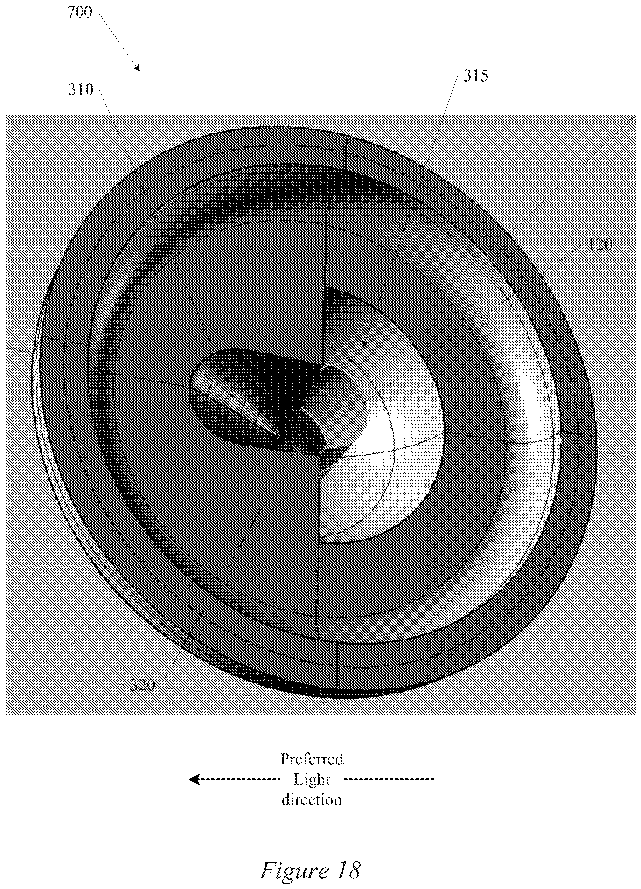

Figure 18 shows an embodiment of a lens 700 having curved reflector 120 and optical element 320 disposed within non-preferred-side void 315. Light may pass through either preferred side void 310 or optical element 320, depending on the longitudinal angle of incident on reflector 120. For example, high angle light (relative to the vertical axis of light emitter 505) will reflect off reflector 120 and exit through lens 700. Low angle light will reflect off reflector 120 and exit through optical element 320.

The terms "invention," "the invention," "this invention" and "the present invention" used in this patent are intended to refer broadly to all of the subject matter of this patent and the patent claims below. Statements containing these terms should not be understood to limit the subject matter described herein or to limit the meaning or scope of the patent claims below. Embodiments of the invention covered by this patent are defined by the claims below and not by the brief summary and the detailed description.

Different arrangements of the components depicted in the drawings or described above, as well as components and steps not shown or described are possible. Similarly, some features and subcombinations are useful and may be employed without reference to other features and subcombinations. Embodiments of the invention have been described for illustrative and not restrictive purposes, and alternative embodiments will become apparent to readers of this patent. Accordingly, the present invention is not limited to the embodiments described above or depicted in the drawings, and various embodiments and modifications can be made without departing from the scope of the claims below.

## Claims

1. A light assembly for distributing light in a preferred direction, the light assembly comprising:
a light emitter (115) having an emitter axis;
a lens (300), positioned over the light emitter, the lens (300) having an outer surface and an inner surface that defines a lens cavity (308); a separate optical element (320) attached to the lens, comprising at least one optical element surface that extends towards the light emitter, wherein the optical element terminates in a tip and wherein a portion of the optical element (320) extends within the lens cavity (308) toward the light emitter (115) and is shaped to refract light emitted from the light emitter toward a non-preferred direction so that the refracted light exits the lens (300) toward the preferred direction; and
a reflector (120) positioned within the lens cavity (308), wherein the reflector (120) is shaped to reflect light emitted from the light emitter (115) toward the non-preferred direction so that the reflected light exits the lens (300) toward the preferred direction.

2. The light assembly of claim 1, wherein the optical element comprises an axis that extends through the tip, wherein the optical element axis is coaxial with the light emitter axis.

3. The light assembly of claim 1, wherein the optical element comprises an axis that extends through the tip, wherein the optical element axis extends parallel to but offset from the light emitter axis.

4. The light assembly of claim 1, wherein the reflector extends at least partially around the light emitter and comprising a circuit board, wherein the reflector is coupled to the circuit board.

5. The light assembly of claim 4, wherein the light emitted from the light emitter toward the non-preferred direction comprises a first portion of light and a second portion of light, wherein the optical element is adapted to refract the first portion of light so that the first portion of light exits the lens in the preferred direction and wherein the reflector is adapted to reflect the second portion of light so that the second portion of light exits the lens in the preferred direction.

6. The light assembly of claim 5, wherein the light emitted from the light emitter away from the preferred direction further comprises a third portion, wherein the reflector is adapted to reflect the third portion of light toward the optical element and wherein the optical element is adapted to refract the reflected third portion of light so that the third portion of light exits the lens in the preferred direction.

7. A method for distributing light from a light fixture, the light fixture including a light emitter (115), a lens (300), an optical element (320) which is separate from the lens and attached to the lens, and a reflector (120), the method comprising:
producing light with the light emitter (115) such that a first portion of the light is initially directed toward a preferred direction, and a second portion of the light and a third portion of the light are initially directed toward a non-preferred direction;
using the optical element (320), refracting the second portion of the light such that the second portion of the light exits the lens (300) towards the preferred direction;
using the reflector (120), reflecting the third portion of the light such that the third portion of the light travels toward the optical element; and
using the optical element (320), refracting the third portion of the light reflected by the reflector such that the third portion of the light exits the lens toward the preferred direction,
wherein the lens (300) has an inner surface which defines a lens cavity (308) comprising a preferred-side void (310) and a non-preferred-side void (315), and
further wherein a portion of the optical element (320) extends within the lens cavity (308) toward the light emitter (115) and the reflector (120) is positioned within the non-preferred-side void (315) of the lens cavity (308).

## Patentansprüche

1. LED-Anordnung zum Verteilen von Licht in eine bevorzugte Richtung, aufweisend:
einen Lichtemitter (115) mit einer Emitterachse,
eine Linse (300), welche über dem Lichtemitter angeordnet ist, wobei die Linse (300) eine äußere Oberfläche und eine innere Oberfläche aufweist, welche einen Linsenhohlraum (308) begrenzt,
ein separates optisches Element (320), das an der Linse angebracht ist, mit wenigstens einer Oberfläche des optischen Elements, die sich in Richtung des Lichtemitters erstreckt, wobei das optische Element in einer Spitze endet und wobei ein Teil des optischen Elements (320) sich innerhalb des Linsenhohlraums (308) in Richtung des Lichtemitters (115) erstreckt und
geformt ist, um Licht, das vom Lichtemitter in eine nicht bevorzugte Richtung emittiert wird, zu brechen, sodass das gebrochene Licht die Linse (300) in einer bevorzugten Richtung verlässt, und
einen Reflektor (120), der in dem Linsenhohlraum (308) angeordnet ist, wobei der Reflektor (120) geformt ist, um Licht, das von dem Lichtemitter (115) in die nicht bevorzugte Richtung emittiert wird, zu reflektieren, so dass das reflektierte Licht die Linse (300) in einer bevorzugten Richtung verlässt.

2. LED-Anordnung nach Anspruch 1, wobei das optische Element eine Achse aufweist, die sich durch die Spitze erstreckt, wobei die Achse des optischen Elements koaxial mit der Emitterachse ist,

3. LED-Anordnung nach Anspruch 1, wobei das optische Element eine Achse aufweist, die sich durch die Spitze erstreckt, wobei die Achse des optischen Elements sich parallel, aber in einem Abstand zu der Emitterachse erstreckt.

4. LED-Anordnung nach Anspruch 1, wobei der Reflektor sich wenigstens teilweise um den Lichtemitter erstreckt, aufweisend eine Leiterplatte, wobei der Reflektor an die Leiterplatte gekoppelt ist.

5. LED-Anordnung nach Anspruch 4, wobei das Licht, das vom Lichtemitter in die nicht bevorzugte Richtung emittiert wird, einen ersten Lichtanteil und einen zweiten Lichtanteil aufweist, wobei das optische Element dazu eingerichtet ist, den ersten Lichtanteil so zu brechen, dass der erste Lichtanteil die Linse in der bevorzugten Richtung verlässt, und wobei der Reflektor dazu eingerichtet ist, den zweiten Lichtanteil so zu reflektieren, dass der zweite Lichtanteil die Linse in der bevorzugten Richtung verlässt.

6. LED-Anordnung nach Anspruch 5, wobei das Licht, das vom Lichtemitter in eine andere als die bevorzugte Richtung emittiert wird, weiterhin einen dritten Lichtanteil aufweist, wobei der Reflektor dazu eingerichtet ist, den dritten Lichtanteil zum optischen Element zu reflektieren, und wobei das optische Element dazu eingerichtet ist, den reflektierten dritten Lichtanteil so zu brechen, dass der dritte Lichtanteil die Linse in der bevorzugten Richtung verlässt.

7. Verfahren zum Verteilen von Licht von einer Leuchte, wobei die Leuchte einen Lichtemitter (115), eine Linse (300), ein optisches Element (320), welches separat von der Linse und an der Linse angebracht ist, und einen Reflektor (120) enthält,
das Verfahren aufweisend:
das Erzeugen von Licht mit dem Lichtemitter (115), so dass ein erster Lichtanteil zu Beginn in eine bevorzugte Richtung emittiert wird, und ein zweiter Lichtanteil und ein dritter Lichtanteil zu Beginn in eine nicht bevorzugte Richtung gerichtet sind,
das Benutzen des optischen Elements (320) zum Brechen des zweiten Lichtanteils, so dass der zweite Lichtanteil die Linse (300) in der bevorzugten Richtung verlässt,
das Benutzen des Reflektors (120) zum Reflektieren des dritten Lichtanteils, so dass der dritte Lichtanteil zum optischen Element gelangt, und
das Benutzen des optischen Elements (320) zum Brechen des dritten Lichtanteils, der vom Reflektor reflektiert wird, so dass der dritte Lichtanteil die Linse in der bevorzugten Richtung verlässt,
wobei die Linse (300) eine innere Oberfläche hat, die einen Linsenhohlraum (308) begrenzt, aufweisend einen Hohlraumabschnitt der bevorzugten Seite (310) und einen Hohlraumabschnitt der nicht bevorzugten Seite (315), und wobei ein Teil des optischen Elements (320) sich innerhalb des Linsenhohlraums (308) in Richtung des Lichtemitters (115) erstreckt, und wobei der Reflektor (120) innerhalb des Hohlraumabschnitts der nicht bevorzugten Seite (315) des Linsenhohlraums (308) angeordnet ist.

## Revendications

1. Ensemble de lumière pour distribuer de la lumière dans une direction préférée, l'ensemble de lumière comprenant :
un émetteur de lumière (115) ayant un axe d'émetteur ;
une lentille (300), positionnée par-dessus l'émetteur de lumière, la lentille (300) ayant une surface extérieure et une surface intérieure qui définit une cavité de lentille (308) ;
un élément optique séparé (320) attaché à la lentille, comprenant au moins une surface d'élément optique qui s'étend vers l'émetteur de lumière, dans lequel l'élément optique se termine dans une pointe et dans lequel une portion de l'élément optique (320) s'étend dans la cavité de lentille (308) vers l'émetteur de lumière (115) et est façonné pour réfracter la lumière émise depuis l'émetteur de lumière vers une direction non préférée de telle sorte que la lumière réfractée sort de la lentille (300) vers la direction préférée ; et
un réflecteur (120) positionné dans la cavité de lentille (308), dans lequel le réflecteur (120) est façonné pour réfléchir de la lumière émise depuis l'émetteur de lumière (115) vers la direction non préférée de telle sorte que la lumière réfléchie sort de la lentille (300) vers la direction préférée.

2. Ensemble de lumière selon la revendication 1, dans lequel l'élément optique comprend un axe qui s'étend à travers la pointe, dans lequel l'axe d'élément optique est coaxial avec l'axe d'émetteur de lumière.

3. Ensemble de lumière selon la revendication 1, dans lequel l'élément optique comprend un axe qui s'étend à travers la pointe, dans lequel l'axe d'élément optique est parallèle à l'axe d'émetteur de lumière mais décalé par rapport à celui-ci.

4. Ensemble de lumière selon la revendication 1, dans lequel le réflecteur s'étend au moins partiellement autour de l'émetteur de lumière et comprenant une carte de circuit, dans lequel le réflecteur est couplé à la carte de circuit.

5. Ensemble de lumière selon la revendication 4, dans lequel la lumière émise depuis l'émetteur de lumière vers la direction non préférée comprend une première portion de lumière et une deuxième portion de lumière, dans lequel l'élément optique est adapté pour réfracter la première portion de lumière de telle sorte que la première portion de lumière sort de la lentille dans la direction préférée et dans lequel le réflecteur est adapté pour réfléchir la deuxième portion de lumière de telle sorte que la deuxième portion sort de la lentille dans la direction préférée.

6. Ensemble de lumière selon la revendication 5, dans lequel la lumière émise depuis l'émetteur de lumière loin de la direction préférée comprend en outre une troisième portion, dans lequel le réflecteur est adapté pour réfléchir la troisième portion de lumière vers l'élément optique et dans lequel l'élément optique est adapté pour réfracter la troisième portion réfléchie de lumière de telle sorte que la troisième portion de lumière sort de la lentille dans la direction préférée.

7. Procédé pour distribuer de la lumière depuis un appareil d'éclairage, l'appareil d'éclairage incluant un émetteur de lumière (115), une lentille (300), un élément optique (320) qui est séparé de la lentille et attaché à la lentille, et un réflecteur (120), le procédé comprenant :
la production de lumière avec l'émetteur de lumière (115) de telle sorte qu'une première portion de la lumière est initialement dirigée vers une direction préférée, et une deuxième portion de la lumière et une troisième portion de la lumière sont initialement dirigées vers une direction non préférée ;
l'utilisation de l'élément optique (320), réfractant la deuxième portion de la lumière de telle sorte que la deuxième portion de la lumière sort de la lentille (300) vers la direction préférée ;
l'utilisation du réflecteur (120), réfléchissant la troisième portion de la lumière de telle sorte que la troisième portion de la lumière se déplace vers l'élément optique ; et
l'utilisation de l'élément optique (320), réfractant la troisième portion de la lumière réfléchie par le réflecteur de telle sorte que la troisième portion de la lumière sort de la lentille vers la direction préférée,
dans lequel la lentille (300) comporte une surface intérieure qui définit une cavité de lentille (308) comprenant un vide côté préféré (310) et un vide côté non préféré (315), et
en outre dans lequel une portion de l'élément optique (320) s'étend dans la cavité de lentille (308) vers l'émetteur de lumière (115) et le réflecteur (120) est positionné dans le vide côté non préféré (315) de la cavité de lentille (308).
